Europäisches Patentamt

(19) European Patent Office

Office européen des brevets

(11) Publication number: **0 007 954**
**B1**

(12) **EUROPEAN PATENT SPECIFICATION**

(45) Date of publication of patent specification: **20.06.84**

(21) Application number: **78900245.8**

(22) Date of filing: **14.11.78**

(86) International application number:
**PCT/JP78/00025**

(87) International publication number:
**WO 79/00293 31.05.79 Gazette 79/11**

(51) Int. Cl.³: **G 01 D 5/243,**
**G 08 C 19/14, F 16 H 21/16**

(54) **QUANTITY CONVERTING AND INDICATING APPARATUS.**

(30) Priority: **14.11.77 JP 136374/77**
**08.11.78 JP 153639/78**

(43) Date of publication of application:
**20.02.80 Bulletin 80/4**

(45) Publication of the grant of the patent:
**20.06.84 Bulletin 84/25**

(84) Designated Contracting States:
**DE FR GB**

(56) References cited:
**DE - A - 2 138 070**
**DE - B - 1 258 305**
**GB - A - 1 356 944**
**JP - B - 31 008 634**
**JP - B - 46 002 958**
**JP - B - 49 047 190**
**JP - B - 50 034 421**
**JP - B - 51 013 423**
**JP - B - 51 022 383**
**US - A - 2 813 677**
**US - A - 3 656 133**

(73) Proprietor: **OSAKA GAS CO., LTD**
**1 Hiranomachi 5-chome, Higashi-ku**
**Osaka-shi, Osaka, 541 (JP)**

(72) Inventor: **OGUCHI, Yuzo**
**691-11 Konami**
**Suwa-shi, Nagano, 392 (JP)**
Inventor: **ITAKURA,Tadayuki**
**324-4, Kobuchizawamachi Kitakoma-gun**
**Yamanashi, 409-16 (JP)**
Inventor: **KAWANO, Akio**
**808-153. Higashigaoka**
**Kishiwada-shi, Osaka, 596 (JP)**

(74) Representative: **Dreiss, Uwe, Dr. jur. Dipl.-Ing.**
**M.Sc. et al,**
**Patentanwälte Dreiss, Hosenthien & Fuhlendorf**
**Gerokstrasse 6**
**D-7000 Stuttgart 1 (DE)**

Courier Press, Leamington Spa, England.

## Description

The invention relates to an apparatus for converting the readings of a supply meter into a binary-coded signal of the type comprising: a plurality of wheels whose rotation is representative of the metered quantity supplied and each of which is formed with alternate circumferential sections of smaller and larger radius respectively, a plurality of vibratable, elongate oscillator members which are fixed at one end and, in the absence of damping, free to vibrate at the other, means to cause said oscillator members to vibrate, and means to sense the vibrations of said oscillator members and to provide an a.c. signal in response thereto.

An apparatus of this kind is described in US—A—3 656 133 and DE—A—2 138 070. In US—A—3 656 133 the supply meter drives a data information signal generator, which is provided in the form of a plurality of rotors, driven with the same speed, which have a number of projections, which coded in a 2-out-of-5-code are an indication of the rotary angle of the rotors; these projections either are in contact with the oscillator members or not. In case of an contact of such a projection member with an oscillator member the oscillator member thereby is prevented from carrying out an oscillation, even when energized by some vibration causing means, such as notches. When the projections do not contact the corresponding oscillating members, they may vibrate, when energized. Thus, for each track around the rotors, on which projections are positioned, at a particular angular position of a rotor, two different states are detectable. The sum of the projections carrying tracks on the rotors therefore is an indication of the actual supply meter indication to be transmitted and to be evaluated accordingly. It is a difficulty with this apparatus, that the projections, which primarily serve the purpose of coding the angular position of the rotors, also are used to directly influence the oscillating means and that, consequently, the position of a great number of projections must be sensed simultaneously ever instant of measuring for the detection of the desired supply meter indication. Further: in their non-energized position, the oscillators are held up by said notches in a deflected position. Releasing them from this position actually is used to cause oscillations, which, as explained, either are damped by said projections or not. This deflected state of the oscillator members in non-energized position is responsible for their being subject to a high wear, exerted upon them in their non-operating state by the high bending force which holds them in their deflecting position. This reduces the lifetime of said apparatus.

In contrast, there is a great demand for apparatus of the type mentioned above, especially for automatic remote-detecting systems, which are used to check the particular readings of supply meters, e.g. for gas, water, or electric power consumption over telephone channels. It is very important, that such readings can be obtained over telephone channels as easy as possible at any time.

One other known apparatus is equipped with a so-called figure-wheel, which gives the readings of the supply meter. This figure-wheel normally carries figures in decimal code. Binary codes corresponding to these decimal code figures are given on that wheel in the form of magnetic information or identation, which is converted to an electric signal by a magnetic head or a microswitch and so on, which is provided along side the wheel. An ac signal modulated by this electrical signal is sent over the telephone channel. In this device, therefore, since the figure-wheel has a singular configuration, an ordinary figure-wheel must be modified for this purpose. Further, since a magnetic head or a microswitch is needed to identify the magnetic information or identation on the figure-wheel, electric circuits for transmission and modulation and the like and a power source to drive this circuits are indispensable.

It is also known from GB—A—1356944 to use digit-adding gears between digit-(figure-) wheels.

Accordingly, it is an object of the present invention to provide an apparatus of the kind mentioned above, which has a construction providing a higher lifetime of the oscillator members than the one discussed in the preceding paragraphs, and improved reliability of the conversion of the angular positions of the previously-mentioned wheels, into a.c. signals.

The invention solves this objective by the following means: in converting apparatus of the above-mentioned type, the wheels are cam members driven by a digit wheel of the measuring counter of said meter, the alternate circumferential sections of each cam member have surfaces which are respectively convex and either concave or of V-shaped cross-section, a plurality of flexible, elongate members, equal in number to that of the oscillator members and cam members, are provided for damping the vibration of said oscillator members, each of which damping members is fixed at one end, has its other end located near to the end of the corresponding oscillator member, and has an intermediate portion between said one and other ends which contacts the surface of the corresponding cam member, the rotation of each cam member causes the surfaces thereof to move the corresponding damping member repetitively to engage, and to disengage, the corresponding oscillator member, to provide an alternate, repetitive damping and vibration of said oscillator member, and digit adding gears are provided between adjacent cam members in order to transmit rotation from one cam member to the adjacent one in accordance with a predetermined gearing ratio.

In this apparatus the readings of the digit- wheel are changed to binary codes by means of the series of cam members. The oscillations of each oscillator member is converted to an AC signal. The frequency of this AC signal is set such as to fit into the allowable frequency band of the transmitting means like the telephone channel. Oscillation of said oscillator members in the present apparatus may be by use of the energy released from storage in spring means such as a coil spring. The present apparatus needs no electric power supply, no intricate electric circuit; with a simple mechanism it can reliably convert the meter-gauge readings to an electric signal favourable for transmission over the telephone channel.

Moreover using the apparatus the existing figure-wheel of the meter-gauge need not be modified at all and the readings-converter can be readily attached to the conventional meter-gauge as it is.

Brief account of the attached drawings

Figure 1 is a front elevation view of a first embodiment of the present invention.

Figure 2 is an elevation view of the principal part of the device in Fig. 1 showing its action.

Figure 3 is a plan view of the same device as viewed in a direction along III—III in Fig. 1.

Figure 4 is an oblique view of a cam member.

Figure 5 (a) shows a waveform of an oscillator member in free oscillation.

Figure 5 (b) shows a waveform of an oscillator member in restricted oscillation.

Figure 6 is a diagram illustrating a regenerating circuit.

Figure 7 shows the waveforms of signals A to H in the regenerating circuit of Fig. 6.

Figure 8 is a front elevation view of a second embodiment of the present invention.

Figure 9 is a plan view of the principal part of the device in Fig. 8.

Figure 10 is an oblique view of a cam member attached to the device in Fig. 8.

Figure 11 is a plan view of the principal part of a third embodiment of the invention.

Figure 12 is a plan view of the principal part of a fourth embodiment of the present invention.

Best mode of carrying out the invention

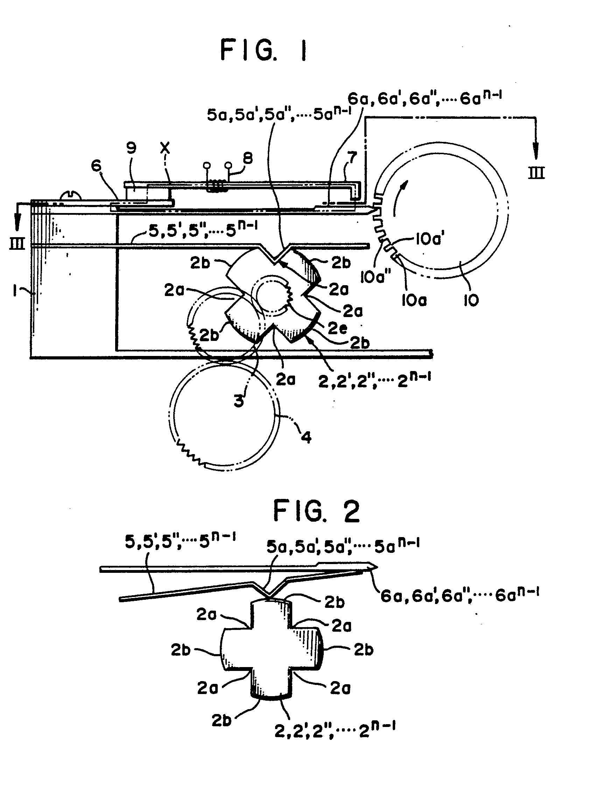

First, referring to Figs. 1—7, the first embodiment of the invention is described.

On the machine frame 1 are arranged cam pieces 2, 2', 2''...$2^{n-1}$, corresponding to the number of digits in the figure to be converted and these pieces are rotatably supported. In the case of a gas meter-gauge which usually gives readings in 8 digits, the upper 4 digits alone may be used with little error and therefore the upper 4 digits alone may be taken as data. Figure 1 shows only the cam piece or member 2 which is the closest of the n pieces to the reader.

On the face of each of cam pieces 2, 2', 2''...$2^{n-1}$ there are formed V-grooves 2a, 2a, 2a, 2a. The convex parts 2b, 2b, 2b, 2b formed on the same face of each cam piece alternate with said V-grooves 2a, 2a, 2a, 2a, separated by a specific distance. On one side of each of said cam pieces 2, 2'...$2^{n-1}$ there are formed successive teeth 2c with a specific interval and on the other side digit-adding teeth 2d staggered in phase by a specific distance from the convex parts 2b, 2b, 2b, 2b, of said cam pieces 2, 2', 2''...$2^{n-1}$. Said digit-adding teeth 2d constitute a sort of imperfect gear.

On the outside of the cam piece 2 which is the closest to the reader there is fitted a small gear 2e, which meshes via an intermediate gear 3 with the figure-wheel 4 of, say, a gas meter-gauge not shown. Said figure-wheel 4 indicates the lowest digit of data to be converted. Meanwhile, inside of the cam piece 2 which is the closest to the reader there are formed successive teeth with an equal interval, just as on the other cam pieces 2', 2'....

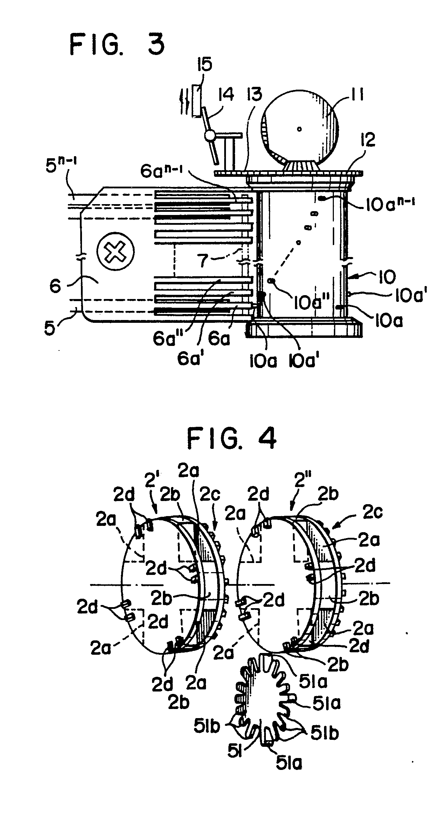

Between the adjoining cam pieces 2, 2'...$2^{n-1}$ there are the digit-adding gears 51, 51, 51...positioned. Now in Fig. 4, the digit-adding gear 51 is rotatably fitted between the cam pieces 2' and 2'' and at particular positions on said gear 51 there are formed wide teeth 51a, 51a.... Between these wide teeth 51a, 51a... come narrow teeth 51b, 51b.... Said narrow teeth 51b, 51b... mesh all the time with the teeth 2c of the cam piece 2', while said wide teeth 51a, 51a... are able to mesh simultaneously with both the teeth 2c of the cam piece 2' and the digit-adding teeth 2d, 2d... of the cam piece 2''.

Hold (or damping) pieces 5, 5', 5''...$5^{n-1}$ made of flexible material have one end fixed to and supported by the machine frame 1 and the other end positioned adjacent the cam pieces 2, 2', 2''...$2^{n-1}$. Since said hold pieces 5, 5', 5''...$5^{n-1}$ correspond respectively to said cam pieces 2, 2',...$2^{n-1}$, said hold pieces correspond respectively also to the oscillator members 6a, 6a'...$6a^{n-1}$ of the oscillation device 6 to be described later. Said hold-pieces 5, 5', 5''...$5^{n-1}$ have V-shaped bends 5a, 5a', 5a''...$5a^{n-1}$ at their mid-portions. Said V-bends normally engage the corresponding faces of said cam pieces 2, 2', 2''...$2^{n-1}$ by virtue of the elasticity of said hold-pieces themselves.

On the machine frame 1 one end of the oscillation device 6 is fixed and on the other end of said device 6 are formed the oscillator members 6a, 6a', 6a''...$6a^{n-1}$ corresponding to the cam pieces 2, 2'...$2^{n-1}$. Said oscillator members 6a, 6a'...$6a^{n-1}$ are equal in length.

A pickup 7 is placed at a specific distance from each of top sides of the oscillator members 6a, 6a', 6a''...$6a^{n-1}$. Said pickup 7 is wound with a coil 8 for taking out output. The end of said pickup 7 is fixed via the magnet 9 to the machine frame 1. Said magnet 9, said pickup 7, said oscillator members 6a, 6a'...$6a^{n-1}$ and said oscillation device 6 constitute a magnetic circuit X.

Ahead of the tip of the oscillator member 6a, 6a', 6a''...6a$^{n-1}$ of the oscillation device 6 there is a drum 10 rotatably supported and on the periphery of said drum 10 just out the pins 10a, 10a', 10a'',...10a$^{n-1}$ to oscillate the oscillator members 6a, 6a', 6a''...6a$^{n-1}$ respectively. Said pins 10a, 10a', 10a''...10a$^{n-1}$, being spirally disposed, can successively flip the oscillator members 6a, 6a', 6a'',...6a$^{n-1}$.

11 denotes a barrel gear such as provided in a music box to hold a spring therein. The energy released from this spring is transmitted as a torque to the drum 10 via the gear wheel 12, thereby causing the drum 10 to rotate. Said gear wheel 12 meshes with another gear wheel 13, which in turn engages a rotatable vane 14. In the vicinity of said vane 14 the control piece 15 can pop out or in within the rotatable range of said vane 14 and said control piece 15 interlocks with a plunger or the like not shown.

The operation in the first embodiment is described here.

The gas meter-gauge is a decimal one in which the digit-(or figure)-wheel 4 rotates by one figure as the figure-wheel 4 of the next lower decimal order changes from "9" to "0". Rotation of the figure-wheel 4 causes the cam piece 2 to turn via the medium gear 3 and the small gear 2e, whereby the cam piece 2 rotates 1/8 turn of the face of the cam piece 2 from the convex part 2b to the V-groove 2a or from the V-groove 2a to the convex part 2b (hereafter 1/8 turn of the cam piece is called one step rotation). When the figure-wheel 4 turns by one more figure and thereby the cam piece 2 makes one step rotation, the digit-adding tooth 2d of the cam piece 2 meshes with a wide tooth 51a of the digit-adding gear 51, whereby the one step rotation of said cam piece 2 is transmitted to the cam piece 2', causing one step rotation of the cam piece 2'. Thus, every two steps of the lower cam piece rotation causes one step rotation of the upper cam piece; and with rotation of the figure-wheel 4, the cam pieces repeat this action successively. In this manner binary digit-adding of the cam pieces 2, 2', 2''...2$^{n-1}$ is done.

If the convex part 2b and the V-groove 2a in the cam pieces 2, 2', 2''...2$^{n-1}$ are made to correspond to the binary code "0" and the binary code "1" respectively, the decimal readings of the figure-wheel 4 in the meter-gauge can be converted to binary ones. If then the V-bends 5a, 5a', 5a''...5a$^{n-1}$ of the hold pieces 5, 5', 5''...5$^{n-1}$ are in engagement with the convex 2b of the cam pieces 2, 2'...2$^{n-1}$, as indicated in Fig. 2, they are bearing against the backside of the corresponding oscillator members 6a, 6a'...6a$^{n-1}$; and if they are in engagement with the V-groove 2a, as indicated in Fig. 1, they are off the corresponding oscillator members 6a, 6a'...6a$^{n-1}$.

Thus as the gauge of gas meter or the like acts and the figure-wheel 4 turns, the cam pieces 2, 2', 2''...2$^{n-1}$ will make step rotation, thereby effecting a decimal-binary conversion of the readings.

Now when you want to check the readings of the meter-gauge, you issue an external signal to make the control piece 15 move upward in Fig. 3, thereby to disengage the vane 14 from the control piece 15.

Then the wheel row 13 becomes free to rotate and the released energy of the coil spring is transmitted via the gear wheel 12 to the drum 10, causing the drum 10 to rotate. With rotation of the drum 10, the pins 10a—10a$^{n-1}$ successively flip the oscillator members 6a—6a$^{n-1}$.

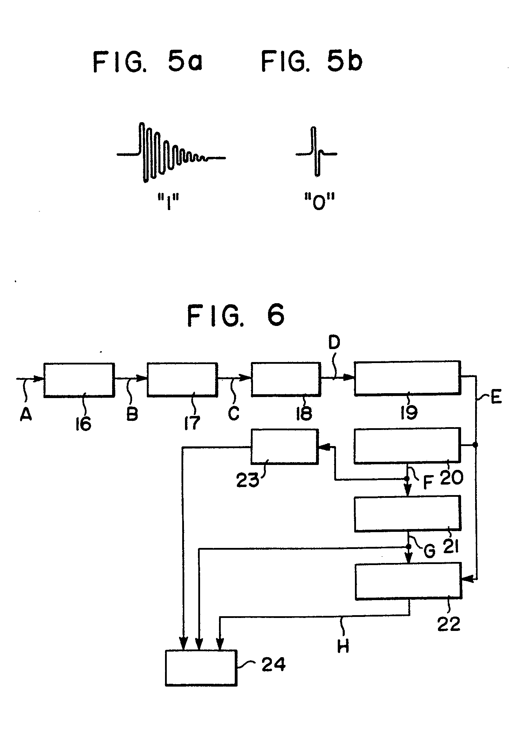

Oscillation of the oscillator members 6a—6a$^{n-1}$ changes the gap between the pickup 7 and the oscillator members 6a—6a$^{n-1}$ and in consequence the magnetic resistance in the magnetic circuit X changes (magnetic flux change), thereby inducing a voltage. This induced voltage has an AC wave form as indicated in Fig. 5, its frequency, which depends on the frequency of the oscillator members 6a—6a$^{n-1}$, being in the range of 300—3000 Hz, which virtually corresponds with the allowable frequency band for a telephone channel etc.

The oscillating mode of the oscillator members differs depending on whether they are being held by the hold pieces 5—5$^{n-1}$ or not. The oscillation lasts long when they are not held by the hold pieces, as shown in Fig. 5(a); and when they are held by the hold pieces, their oscillation, being absorbed by said hold pieces as shown in Fig. 5(b), immediately ceases. Thus from the output end of the coil 8 emerge successive waveforms as shown in Fig. 5(a) or (b) in binary representation given by the cam pieces 2—2$^{n-1}$.

In the first embodiment in which the data are produced in series, the oscillator members 6a—6a$^{n-1}$ have only to be approximately equal in length and there is no need to set an exact frequency of the oscillator members 6a—6a$^{n-1}$ by tuning the valve.

The waveforms are transmitted over a telephone channel by a transmitting means not shown and received by the receiving circuit as shown in Fig. 6. The receiving action is explained as follows.

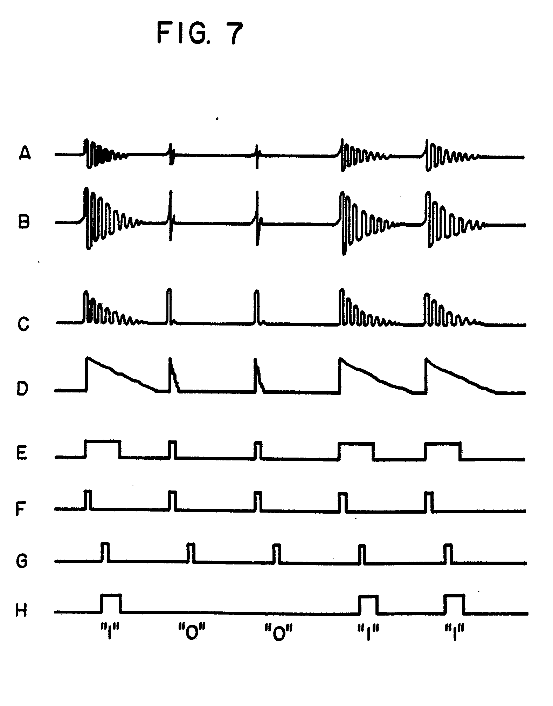

First a waveform as illustrated by A in Fig. 7 which comes over the telephone channel is amplified by the amplifier 16, yielding a waveform B. The waveform B is detected by the wave detector 17, yielding a waveform C. The waveform C is smoothed by the smoothing circuit 18, yielding a waveform D. The waveform D is detected at a specific level by the level detecting circuit 19, yielding a rectangular waveform E. The waveform E is long when it has a pulse width "1" and short when it has a pulse width "0". Upon a signal of E waveform rise, the pulse generator 20 produces a series of pulses F with a specific width. This series of pulses F is given a specific delay by the delay circuit 21, yielding a waveform G. The waveform G and the waveform E are compared by the discriminating circuit 22. If the waveform E is high-level in the presence of a pulse of the waveform G, the logic "1" is generated; and if the waveform E is low-level, the logic "0" is generated. Meanwhile the counter 23 counts the waveform F so that an "end" signal can be issued when a specific number of pulses comes. Upon the "end" signal the control piece 15 is shifted downward in Fig. 3 to stop the rotation of the drum. If the waveforms G and H, and the "end" signal are fed to CPU 24, a computerized meter-checking be realized.

In the above description, only the data on the binary readings of the counter are issued from the oscillator members $6a$—$6a^{n-1}$, but it may be so designed with an increased number of oscillator members, hold pieces and pins that a "data start" signal, a "data end" signal etc. can be issued. When data is not transmitted over the telephone channel, microswitches or piezoelectric elements may be set in opposition to the cam pieces $2$—$2^{n-1}$ so that the V-groove 2a or convex part 2b of the cam piece can be sensed and the binary code there can be converted to an electric signal.

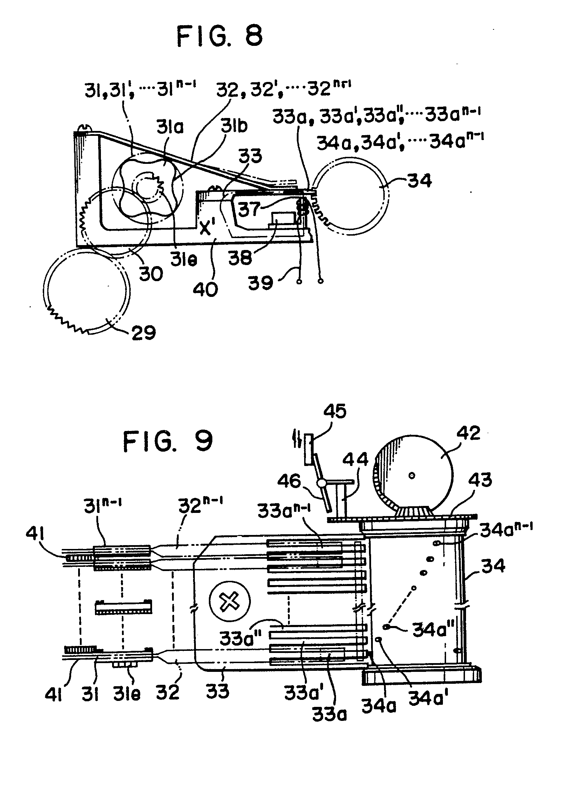

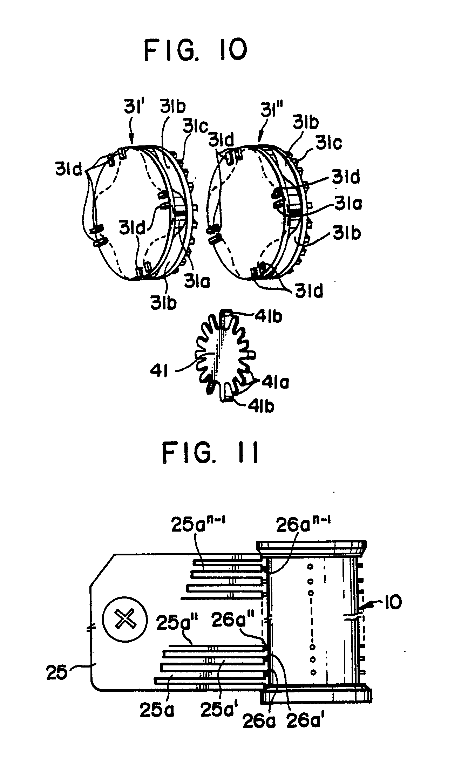

Figures 8 to 10 illustrate the second embodiment of the present invention. 29 denotes a figure-(or digit-) wheel in a gas- or water meter-gauge which indicates the lowest digit of the readings to be taken by the figure-wheel. 31, $31'...31^{n-1}$ are binary cam pieces which are arranged parallel in quantities matching the digits of data. On the outer circumference of each cam piece, convex 31a and concave parts 31b are provided alternately. On one side of the cam piece the teeth 31c are arranged at equal intervals and on the other side the digit-adding teeth 31d are provided a little apart from the convex 31a.

Between adjacent cam pieces there are digit-adding gears 41, on which the wide teeth 41b which mesh with both the teeth 31c and the digit-adding teeth 31d are provided at equal intervals and the narrow teeth 41a which mesh only with the teeth 31c are provided at equal intervals between said wide teeth 41b.

30 is a medium gear to transmit the rotation of the figure-wheel 29 to the gear 31e integrated to the lowest cam piece 31. $32$—$32^{n-1}$ are hold (or damping) pieces with one end fixed to the base 40, the other end opposing to and free to contact with the oscillator members $33a$—$33a^{n-1}$ of the oscillating device 33 and the middle part bearing against the concave 31b or the convex 31a of the cam pieces $31$—$31^{n-1}$. The oscillator members $33a$—$33a^{n-1}$ are equal in length. A pick-up 37 is provided with a specific gap to the bottom of the oscillators $33a$—$33a^{n-1}$. A magnet 38 is fitted to this pickup 37. Said magnet 38, said pickup 37, the base frame 40, the oscillation device 33, and the oscillator members $33a$—$33a^{n-1}$ constitute a magnetic circuit X'.

The pickup 37 is wound with a coil 39, which gives an output from its end. 42 is a barrel provided in, say, a music box and it holds a coil spring therein. The released energy of this coil spring is transmitted as a torque to the drum 34 via the gear wheel 43, 46 is a weather vane to which a torque of the gear wheel 43 is transmitted via the gear wheel 44 and which is rotated in the arrow direction. 45 is a control piece which pops in or out of the range of movement of the vane 46 and it is operated by an external signal. $34a$—$34a^{n-1}$ are pins arranged spirally around the drum 34 so that they can successively flip the oscillators $33a$—$33a^{n-1}$. The constitution of a well-known music box applies to said oscillation valve 33, drum 34, barrel 42, gear wheels 43, 44 and vane 46.

Supposing the above constitution, the action in the second embodiment of Figs. 8—10 is described here.

The figure-wheel 29 turns one figure only, as the reading of the lower figure-wheel changes from "9" to "0". This turning of the figure-wheel 29 is transmitted by the medium gear 30 to the cam piece 31, causing 1/8 rotation from the convex (31a) to the concave (31b) part or from the concave (31b) to the convex (31a) part (hereafter this action is called one step rotation). Next, when the figure-wheel 29 turns for one figure and the cam piece 31 makes one step rotation, the digit-adding teeth 31d of the cam piece 31 mesh with the wide teeth 41b of the digit-adding gear 41, whereby one step rotation of the cam piece 31 is transmitted to the cam piece 31', causing one step rotation of the cam piece 31'. In other words, for every two steps of the rotation of a lower cam piece, an upper cam piece makes one step rotation and by successive repetition of this action binary digit-adding can be done by the cam pieces $31$—$31^{n-1}$.

If the convex part 31a of the cam piece is deemed "1" and the concave part 31b of it is deemed "0", the cam pieces $31$—$31^{n-1}$ can convert the decimal readings of the meter-gauge to the binary ones. The hold pieces $32$—$32^{n-1}$ take a one dot-chain line position of Fig. 8 when they are pressed by the convex 31a of the corresponding cam pieces $31$—$31^{n-1}$; and they are off the corresponding oscillator members $33a$—$33a^{n-1}$. When they come opposite to the concave 31b, they take a solid line position of Fig. 8 and at this position they are in contact with the corresponding oscillator members $33a$—$33a^{n-1}$.

When you want to check the readings of the gauge, you give an external signal to shift the control piece 45 upward in Fig. 9, thereby disengaging it from the vane 46.

Thereupon the wheel row 44 becomes free to rotate and the released energy of the spring is transmitted as a torque to the drum 34 via the wheel row 43. Subsequent process is the same as in the first embodiment.

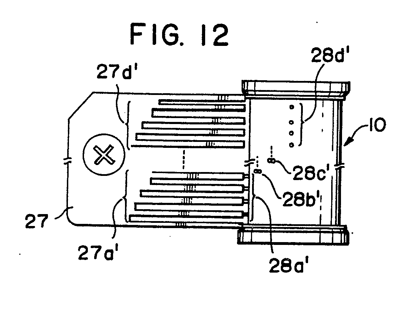

Figure 11 illustrates the third embodiment of the invention.

The feature of this embodiment lies in that the oscillator members $25a$—$25a^{n-1}$ formed on the oscillation device 25 are designed progressively shorter and the pins $26a$—$26a^{n-1}$ jutting from the drum 10 are arranged parallel in a row. Since the oscillator members $25a$—$25a^{n-1}$ are thus progressively shorter in this embodiment, their frequencies are progressively higher. If such oscillator members and drum are applied in the first and second embodiments, it will be possible to obtain an output waveform of mixed frequency of each one from the output ends of the coils 8, 39 by making the pins $26a$—$26a^{n-1}$ simultaneously flip these oscillator members $25a$—$25a^{n-1}$, because these oscillator members matching respective digits of the binary code have entirely different frequencies. When said output waveform is reproduced at the receiving end, the data can be reproduced by separating the frequency components through filters corresponding to respective frequencies. This is not a case of transmitting the data in series as in the preceding embodiments, but a case of transmitting them in parallel; therefore the transmitting time can be cut down.

Figure 12 illustrates the fourth embodiment of the invention. The feature of this embodiment lies in that the binary codes representing the figures on the figure-wheel are made to match the oscillator member sets $27a'$—$27d'$ of the oscillation device 27 and these oscillator member sets are successively flipped by the pin sets $28a'$—$28d'$, whereby an AC signal comprising four frequency components is obtained from the output ends of the coils 8, 39. The data of the figure-wheel can be taken out in series by repeating this process until the oscillator set $27d'$ is flipped by the pin set $28d'$. Needless to say, the mixed frequency components in the AC signal can be simply separated by passing them through a filter of each frequency at the receiving end.

Industrial applicability of the invention:

The converter of meter-gauge readings according to the present invention can be applied at home or plant; it is highly useful for checking the readings of a gas-, a water- or a electric power meter-gauge by automatic remote-control method; and being simple in constitution, low-cost and exact in measuring, it has potentially great industrial applicability.

## Claims

1. Apparatus for converting the readings of a supply meter into a binary-coded signal comprising:

— a plurality of wheels (2, 2', 2''...$2^{n-1}$; 31, 31', 31''...$31^{n-1}$) whose rotation is representative of the metered quantity supplied and each of which is formed with alternate circumferential sections (2a, 2b) of smaller and larger radius respectively,

— a plurality of vibratable, elongate oscillator members (6a, 6a', 6a''...$6a^{n-1}$; 33a, 33a', 33a''...$33a^{n-1}$; 25a, 25a', 25a''...$25a^{n-1}$; 27a',...27d') which are fixed at one end and, in the absence of damping, free to vibrate at the other,

— means (10) to cause said oscillator members to vibrate,

— means (7) to sense the vibrations of said oscillator members and to provide an a.c. signal in response thereto,

characterised in that:

— the wheels are cam members driven by a digit wheel (4) of the measuring counter of said meter,

— the alternative circumferential sections (2a, 2b) of each cam member have surfaces which are respectively convex and either concave or of V-shaped cross-section,

— a plurality of flexible, elongate members (5, 5', 5''...$5^{n-1}$; 32, 32', 32''...$32^{n-1}$), equal in number to that of the oscillator members and cam members, are provided for damping the vibration of said oscillator members, each of which damping members is fixed at one end, has its other end located near to the end of the corresponding oscillator member, and has an intermediate portion between said one and other ends which contacts the surface of the corresponding cam member,

— the rotation of each cam member causes the surfaces thereof to move the corresponding damping member repetitively to engage, and to disengage, the corresponding oscillator member, to provide an alternate, repetitive damping and vibration of said oscillator member, and

— digit adding gears (51, 41) are provided between adjacent cam members in order to transmit rotation from one cam member to the adjacent one in accordance with a predetermined gearing ratio.

2. Apparatus as claimed in claim 1, wherein, when said cam member is provided with surfaces of V-shaped cross section, a V-shaped bend (5a, 5a', 5a''...$5a^{n-1}$) to engage said V-groove is provided on an intermediate part of each said damping member (5, 5', 5''...$5^{n-1}$); and said damping members are flat blade-shaped springs.

3. Apparatus as claimed in claim 1, wherein said oscillator members (6a, 6a', 6a''...$6a^{n-1}$; 33a, 33a', 33a''...$33a^{n-1}$; 25a, 25a'...$25a^{n-1}$; 27a'...27d') are provided as the teeth of a comb-like member, the spine (6; 33; 25; 27) of which is fixed.

4. Apparatus as claimed in claim 1 or 3, wherein said means (10) to cause oscillation of said oscillator members ($6a$, $6a'$, $6a''...6a^{n-1}$; $33a$, $33a'$, $33a''...33a^{n-1}$; $25a$, $25a'...25a^{n-1}$; $27a'...27d'$) is constituted by a drum (10; 34) having a plurality of pins ($10a$, $10a'...10a^{n-1}$; $34a$, $34a'...34a^{n-1}$; $26a$, $26a'...26a^{n-1}$; $28a'$, $28b'$, $28c'$, $28d'$) projecting from its outer surface, a spring to drive and rotate said drum, and a governor (13; 3; 44) to control the relaxation of said spring.

5. Apparatus as claimed in claim 4, wherein said pins ($10a$, $10a'...10a^{n-1}$; $34a$, $34a'...34a^{n-1}$) of said drum (10; 34) are disposed spirally around its outer surface.

6. Apparatus as claimed in claim 4, wherein said pins ($26a$, $26a'...26a^{n-1}$; $28a'$, $28b'$, $28c'$, $28d'$) of said drum (10; 34) are arranged in parallel circumferential lines and said oscillator members ($25a$, $25a'$, $25a''...25a^{n-1}$) have different vibration frequencies.

7. Apparatus as claimed in claim 4, wherein said oscillator members are provided in sets ($27a'...27d'$) and said pins are arranged in sets ($28a'...28d'$) corresponding to said sets of oscillator members ($27a'...27d'$).

8. Apparatus as claimed in anyone of claims 1 to 7, wherein said sensing means (7) is constituted by a pickup (7) attached to a frame (1), a coil (8) wound around said pickup, and a magnet (9) to generate a magnetic flux in a magnetic circuit (X; X') constituted by said oscillator members, said frame and said pickup.

9. Apparatus as claimed in claim 4, wherein said governor consists of a gear (12; 13; 43; 44) and a vane mechanism (14; 46) which is rotated by said gear.

10. Apparatus as claimed in claim 9, wherein a control member (15; 45) is provided to be moved into or out of the rotational field of said vane mechanism (14, 46).

**Revendications**

1. Appareil pour la conversion des indications d'un compteur en un signal binaire comprenant:

— une pluralité de roues ($2$, $2'$, $2''...2^{n-1}$; $31$, $31'$, $31''...31^{n-1}$) dont la rotation est représentative de la quantité mesurée et dont chacune d'elles présente des secteurs circonférentiels alternés ($2a$, $2b$) respectivement à rayons plus petits et à rayons plus grands,
— une pluralité d'éléments oscillants allongés susceptibles de vibrer ($6a$, $6a'$, $6a''...6a^{n-1}$; $33a$, $33a'$, $33a''...33a^{n-1}$; $25a$, $25a'$, $25a''...25a^{n-1}$; $27a'...27d'$) qui sont fixés à une extrémité et libres de vibrer à leur autre extrémité en l'absence d'amortissement,
— des moyens (10) provoquant la vibration des éléments oscillants,
— des moyens (7) de détection des vibrations des éléments oscillants et d'envoi d'un signal alternatif en réponse à ces oscillations,

caractérisé en ce que:

— les roues sont des cames entraînées par une roue à chiffres (4) du mécanisme de mesure du compteur,
— les secteurs circonférentiels alternés ($2a$, $2b$) de chaque came ont des surfaces qui sont respectivement soit convexe, soit concave ou à section droite à profil en V,
— une pluralité de pièces flexibles allongées ($5$, $5'$, $5''...5^{n-1}$; $32$, $32'$, $32''...32^{n-1}$), en nombre égal à celui des éléments oscillants et des cames, sont prévues pour amortir les vibrations des éléments oscillants, chacune de ces pièces d'amortissement étant fixée à une extrémité et ayant son extrémité opposée disposée à proximité de l'extrémité d'un élément oscillant correspondant, avec une partie intermédiaire entre ces extrémités qui est en contact avec la surface d'une came correspondante,
— la rotation de chaque came fait que les surfaces de celle-ci déplacent la pièce d'amortissement correspondante pour qu'elle s'engage avec l'élément oscillant correspondant ou s'en dégage de façon répétitive afin d'engendrer une vibration et un amortissement répétitifs alternés de cet élément oscillant,
— des roues de report (51, 41) sont disposées entre les cames voisines afin de transmettre la rotation d'une came à la came voisine conformément à un rapport d'engrènement prédéterminé.

2. Appareil selon la revendication 1 caractérisé en ce que lorsque les cames ont des surfaces à section droite à profil en V, une pliure en V ($5a$, $5a'$, $5a''...5a^{n-1}$) est prévue sur une partie intermédiaire de chaque pièce d'amortissement 5, $5'$, $5''...5^{n-1}$) pour venir s'engager avec cette rainure en V, lesdites pièces d'amortissement étant des ressorts plats semblables à des lamelles.

3. Appareil selon la revendication 1 caractérisé en ce que les éléments oscillants ($6a$, $6a'$, $6a''...6a^{n-1}$; $33a$, $33a'$, $33a''...33a^{n-1}$; $25a$, $25a'...25a^{n-1}$; $27a'...27d'$) sont disposés comme les dents d'un peigne dont la partie commune (6, 33, 25, 27) est fixe.

4. Appareil selon l'une quelconque des revendications 1, 3, caractérisé en ce que le moyen (10) qui provoque l'oscillation des éléments oscillants ($6a$, $6a'$, $6a''...6a^{n-1}$; $33a$, $33a'$, $33a''...33a^{n-1}$; $25a$, $25a'...25a^{n-1}$; $27a'...27d'$) est constitué par un tambour (10, 34) ayant une pluralité d'ergots ($10a$, $10a'...10a^{n-1}$; $34a$, $34a'...34a^{n-1}$; $26a$, $26a'...26a^{n-1}$; $28a'$, $28b'$, $28c'$, $28d'$) en saillie à partir de sa surface extérieure, un ressort pour entraîner et faire tourner ce tambour, et un moyen de commande (13, 3, 44) pour commander la détente de ce ressort.

5. Appareil selon la revendication 4 caractérisé en ce que les ergots (10a, 10a'...10a$^{n-1}$; 34a, 34a'...34a$^{n-1}$) du tambour (10, 34) sont disposés en spirale autour de sa surface extérieure.

6. Appareil selon la revendication 4 caractérisé en ce que les ergots (26a, 26a'...26a$^{n-1}$; 28a', 28b', 28c', 28d') du tambour (10, 34) sont disposés sur des lignes circonférentielles parallèles et les éléments oscillants (25a, 25a', 25a''...25a$^{n-1}$) ont des fréquences de vibration différentes.

7. Appareil selon la revendication 4 caractérisé en ce que les éléments oscillants sont disposés en jeux (28a'...27d') et les ergots sont disposés en jeux (28a'...28d') correspondants à ces jeux d'éléments oscillants (27a'...27d').

8. Appareil selon l'une quelconque des revendications 1 à 7 caractérisé en ce que le moyen de détection (7) est constitué par un capteur (7) attaché à un châssis (1), portant un enroulement (8) avec un aimant (9) pour engendrer un flux magnétique dans un circuit magnétique (X, X') constitué par ces éléments oscillants, ce châssis et ce capteur.

9. Appareil selon la revendication 4, caractérisé en ce que le moyen de commande comprend une roue dentée (12; 13; 43; 44) et un mécanisme à ailette (14; 46) qui est entraîné par cette roue dentée.

10. Appareil selon la revendication 9 caractérisé en ce qu'un organe de commande (15; 45) est prévu pour être déplacé et être mis sur la trajectoire ou en dehors de la trajectoire de rotation du mécanisme à ailette (14; 46).

**Patentansprüche**

1. Gerät zur Umwandlung der Anzeige eines Förder-Messgerätes in ein binär codiertes Signal, enthaltend:

— Eine Vielzahl von Rädern (2, 2', 2''...2$^{n-1}$; 31, 31', 31''...31$^{n-1}$), deren Drehung die gemessene geförderte Menge darstellt und von denen jedes entlang seines Umfangs abwechselnd Bereiche kleineren und Bereiche größeren Radius aufweist,

— eine Vielzahl von in Schwingung versetzbaren länglichen Oscillatorteilen (6a, 6a', 6a''...6a$^{n-1}$; 33a, 33a', 33a''...33a$^{n-1}$; 25a, 25a', 25a''...25a$^{n-1}$; 27a',...27d') die an einem Ende fixiert sind und, in Abwesenheit einer Dämpfung, am anderen Ende frei sind, um eine Schwingung zu ermöglichen,

— Mittel (10), um die genannten Oscillatorteile in Schwingung zu versetzen;

— Mittel (7), um die Vibrationen der genannten Oscillatorteile festzustellen und daraufhin ein Wechselstromsignal zu erzeugen,

dadurch gekennzeichnet, daß:

— Die Rädar sind Nockenteile, die von einem Ziffernrad (4) des Meßzähler des genannten Meßgerätes angetrieben werden,

— die sich abwechselnden Bereiche entlang des Umfangs (2a, 2b) jedes Nockenteiles haben Oberflächen, die konvex bzw. entweder konkav oder von V-förmigem Querschnitt sind,

— eine Vielzahl flexibler länglicher Teile, (5, 5', 5''...5$^{n-1}$; 32, 32', 32''...32$^{n-1}$), deren Zahl gleich der der Oscillatorteile und der Nockenteile ist, ist vorgesehen, um die Vibrationen der genannten Oscillatorteile zu dämpfen, wobei jeder dieser Dämpferteile an einem Ende fixiert ist und sein anderes Ende in Nähe des Endes des zugeordneten Oscillatorteiles angeordnet ist, und ferner ein Mittelbereich zwischen den ersterwähnten und den anderen Enden vorgesehen ist, der in Kontakt mit der Oberfläche des zugeordneten Nockenteiles ist,

— die Bewegung jedes Nockenteiles bewirkt, daß dessen Oberflächen die entsprechenden Dämpferteile derart bewegen, daß diese repetierend auf die entsprechenden Oscillatorteile einwirken bzw. wirkungsmäßig von ihnen getrennt sind, so daß sich daraus eine abwechselnde repetierende Dämpfung und Vibration des Oscillatorteiles ergibt, und

— digitale Additions-Zahnräder (51, 41) sind zwischen aneinander angrenzenden Nockenteilen vorgesehen, um die Rotation von einem Nockenteil auf den benachbarten Nockenteil entsprechend einem vorbestimmten Übersetzungsverhältnis zu übertragen.

2. Gerät, wie in Anspruch 1 beansprucht, bei dem, wenn der genannte Nockenteil mit Oberflächen mit V-förmigem Querschnitt versehen ist, an einem mittleren Bereich jedes der genannten Dämpferteile (5, 5', 5''...5$^{n-1}$) eine V-förmige Beigung (5a, 5a', 5a''...5a$^{n-1}$) vorgesehen ist, die in den genannten V-Einschnitt eingreift; und wobei die genannten Dämpferteile flache klingenförmige Federn sind.

3. Gerät, wie in Anspruch 1 beansprucht, bei dem die genannten Oscillatorteile (6a, 6a', 6a''...6a$^{n-1}$; 33a, 33a', 33a''...33a$^{n-1}$; 25a, 25a'...25a$^{n-1}$; 27a'...27d') als Zähne eines kammähnlichen Teiles ausgebildet sind, dessen Rücken (6; 33; 25; 27) fixiert ist.

4. Gerät, wie in Anspruch 1 oder 3 beansprucht, bei dem die genannten Mittel (10), die die Vibration der genannten Oscillatorteilen herbeiführen (6a, 6a', 6a''...6a$^{n-1}$; 33a, 33a', 33a''...33a$^{n-1}$; 25a, 25a'...25$^{n-1}$; 27a'...27d') durch eine Trommel (10; 34) gebildet werden, die mit einer Vielzahl von Stiften (10a, 10a'...10a$^{n-1}$; 34a, 34a'...34a$^{n-1}$; 26a, 26a'...26a$^{n-1}$; 28a', 28c', 28d') versehen ist, die aus ihrer äußeren Oberfläche hervorstehen, ferner durch eine Feder, die die Trommel antreibt und dreht, sowie einen Regler (13; 3; 44), der die Entspannung der genannten Feder bestimmt.

5. Gerät, wie in Anspruch 4 beansprucht, bei dem die genannten Stifte ($10a$, $10a'...10a^{n-1}$; $34a$, $34a'...34a^{n-1}$) der genannten Trommel ($10$; $34$) spiralenförmig entlang ihrer äußeren Oberfläche angeordnet sind.

6. Gerät, wie in Anspruch 4 beansprucht, bei dem die genannten Stifte ($26a$, $26a'...26a^{n-1}$; $28a'$, $28b'$, $28c'$, $28d'$) der genannten Trommel ($10$; $34$) in parallelen, entlang des Umfangs verlaufenden Linien angeordnet sind, und die genannten Oscillatorteile ($25a$, $25a'$, $25a''...25a^{n-1}$) verschiedene Vibrationsfrequenzen haben.

7. Gerät wie in Anspruch 4 beansprucht, bei dem die genannten Oscillatorteile in Gruppen ($27a'...27d'$) vorgesehen sind, und die genannten Stifte in Gruppen ($28a'...28d'$) angeordnet sind, die den genannten Oscillatorteilen ($27a'...27d'$) entsprechen.

8. Gerät, wie in einem der Ansprüche 1 bis 7 beansprucht, bei dem die genannten Mittel (7) zur Feststellung der Vibrationen durch einen am Rahmen (1) angebrachten Aufnahmeteil (7), eine um den Aufnahmeteile gewickelte Spule (8) und einen Magneten (9) gebildet werden, der einen magnetischen Fluß in einem magnetischen Kreis ($X$, $X'$) erzeugt, welch magnetischer Kreis durch die genannten Oscillatorteile, den Rahmen und den Aufnahmeteil gebildet wird.

9. Gerät, wie in Anspruch 4 beansprucht, bei dem der genannte Regler durch ein Getriebe (12; 13; 43; 44) und einen Flügelmechanismus (14; 46) gebildet wird, der durch das genannte Getriebe angetrieben wird.

10. Gerät, wie in Anspruch 9 beansprucht, in dem ein Steuerteil (15; 45) vorgesehen ist, das in das Drehfeld des genannten Flügelmechanismus (14, 46) hineingeschoben und aus diesem wieder herausbewegt werden kann.

# FIG. 1

# FIG. 2

# FIG. 3

# FIG. 4

# FIG. 5a    FIG. 5b

"I"        "O"

# FIG. 6

# FIG. 7

# FIG. 8

# FIG. 9

5

# FIG. 10

# FIG. 11

FIG. 12